# FASCICULE DE BREVET EUROPEEN

(11) **EP 4 350 368 B1**
(45) Date de publication et mention de la délivrance du brevet: **02.07.2025**
(21) Numéro de dépôt: 23201379.7
(22) Date de dépôt: 03.10.2023
(51) Int. Cl.: G01R 31/12, H01B 7/32, H02H 1/00

(54) **HARNAIS ÉLECTRIQUE COMPRENANT UN SYSTÈME DE PROTECTION ÉLECTROMAGNÉTIQUE AINSI QU UN SYSTÈME DE DÉTECTION D'ARCS ÉLECTRIQUES ET PROCÉDÉ DE FABRICATION D'UN TEL HARNAIS ÉLECTRIQUE**
ELEKTRISCHER KABELBAUM MIT ELEKTROMAGNETISCHEM SCHUTZSYSTEM SOWIE LICHTBOGENDETEKTIONSSYSTEM UND VERFAHREN ZUR HERSTELLUNG EINES SOLCHEN KABELBAUMS
ELECTRICAL HARNESS COMPRISING AN ELECTROMAGNETIC PROTECTION SYSTEM AND AN ELECTRICAL ARC DETECTION SYSTEM AND METHOD FOR MANUFACTURING SUCH AN ELECTRICAL HARNESS

(30) Priorité: 04.10.2022 FR 2210113
(43) Date de publication de la demande: 10.04.2024
(73) Titulaire: Airbus SAS, 31700 Blagnac (FR)
(72) Inventeur: DESJEAN, Christophe, 31700 BLAGNAC (FR); CHASSAIGNE, Didier, 31700 BLAGNAC (FR); FORGET, Frédéric, 31700 BLAGNAC (FR)
(74) Mandataire: Fantin, Laurent

(56) Documents cités:
- EP-B1- 3 361 587
- WO-A1-96/27197
- CN-A- 112 578 226
- DE-A1- 102004 051 734
- FR-A1- 3 069 658
- FR-A1- 3 101 195

## Description

La présente demande se rapporte à un harnais électrique comprenant un système de protection électromagnétique et un système de détection d'arcs électriques ainsi qu'à un procédé de fabrication d'un tel harnais électrique.

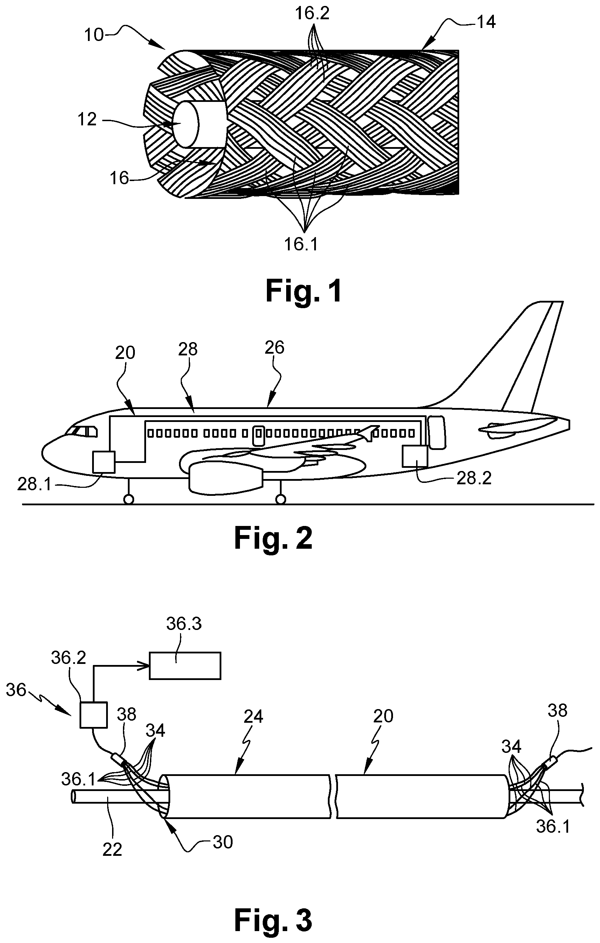

Selon un mode de réalisation visible sur la figure 1, un harnais électrique 10 comprend au moins une liaison électrique 12 comportant au moins un élément conducteur ainsi qu'un système de protection électromagnétique 14 comportant une enveloppe tubulaire 16, entourant la liaison électrique 12, obtenue par tressage de fuseaux 16.1 de brins métalliques 16.2. Selon une configuration, l'enveloppe tubulaire 16 comprend seize fuseaux 16.1 de cinq brins métalliques 16.2 chacun.

Le document FR3101195 décrit une liaison électrique équipée d'un système de détection d'arcs électriques. Selon ce document, la liaison électrique comprend un conducteur électrique entouré d'une enveloppe isolante. En complément, le système de détection d'arc électrique comprend une nappe textile, composée d'une pluralité de fibres optiques et de fils de trame transparents (laissant passer la lumière), enroulée autour de l'enveloppe isolante, un composant de photo-détection configuré pour recevoir un faisceau lumineux guidé par les fibres optiques et émettre un signal électrique en fonction du faisceau lumineux reçu ainsi qu'une commande configurée pour contrôler le coupe-circuit en fonction du signal électrique émis par le composant de photo-détection. Ainsi, en cas d'apparition d'un arc électrique, le flux lumineux généré par ce dernier est capté par les fibres optiques qui le transmettent au composant photo-détection qui génère un signal électrique envoyé à un dispositif d'ouverture du circuit (en anglais "circuit breaker").

L'intégration d'un système de protection électromagnétique et d'un système de détection d'arcs électriques sur le même harnais électrique n'est pas optimale car elle nécessite deux enveloppes tubulaires coaxiales, une pour chaque système, ce qui conduit à augmenter significativement la masse du harnais électrique.

Un autre document pertinent de l'état de la technique est CN 112 578 226 A.

La présente invention vise à remédier à tout ou partie des inconvénients de l'art antérieur.

A cet effet, l'invention a pour objet un harnais électrique comportant :
- au moins une liaison électrique,
- un système de protection électromagnétique comportant une enveloppe tubulaire obtenue par tressage de fuseaux de brins et positionnée autour de la liaison électrique, au moins 80% des brins des fuseaux étant métalliques,
- un système de détection d'arcs électriques comportant au moins une fibre optique positionnée à proximité de la liaison électrique et au moins un composant de photo-détection configuré pour recevoir un faisceau lumineux guidé par la fibre optique.

Selon l'invention, l'enveloppe tubulaire comprend des brins sous la forme de tronçons de fibre optique formant au moins une partie du système de détection d'arcs électriques.

Selon l'invention, les brins sous la forme de tronçons de fibre optique ont un diamètre sensiblement identique à celui des brins métalliques.

Selon l'invention, la même enveloppe tubulaire comprend des brins métalliques formant au moins une partie du système de protection électromagnétique ainsi que des brins sous la forme de tronçons de fibre optique formant au moins une partie du système de détection d'arcs électriques. Cette solution contribue à réduire la masse d'un harnais électrique intégrant les fonctions de protection électromagnétique et de détection d'arcs électriques.

Selon une autre caractéristique, pour au moins une moitié des fuseaux de l'enveloppe tubulaire, tous les brins sont métalliques alors que pour les autres fuseaux de l'enveloppe tubulaire, au moins 75% des brins sont métalliques.

Selon un mode de réalisation, l'enveloppe tubulaire comprend seize fuseaux ainsi que quatre brins, chacun sous la forme d'un tronçon de fibre optique, régulièrement répartis autour de la liaison électrique dans quatre fuseaux.

Selon un autre mode de réalisation, l'enveloppe tubulaire comprend seize fuseaux ainsi que huit brins, chacun sous la forme d'un tronçon de fibre optique, régulièrement répartis autour de la liaison électrique dans huit fuseaux.

Selon une autre caractéristique, chaque fibre optique est une fibre optique monomode ou multimode.

Selon une autre caractéristique, les tronçons de fibre optique sont reliés en parallèle.

Selon une autre caractéristique, chaque brin sous la forme d'un tronçon de fibre optique s'étend sur toute la longueur de l'enveloppe tubulaire et présente au moins une surlongueur à au moins une extrémité de l'enveloppe tubulaire.

L'invention a également pour objet un procédé de fabrication d'un harnais électrique selon l'une des caractéristiques précédentes. Selon l'invention, l'enveloppe tubulaire est obtenue par un surtressage simultané, sur la liaison électrique, de brins métalliques formant au moins une partie du système de protection électromagnétique ainsi que de brins sous la forme de tronçons de fibre optique formant au moins une partie du système de détection d'arcs électriques.

L'invention a également pour objet un aéronef comprenant au moins un harnais électrique selon l'une des caractéristiques précédentes.

D'autres caractéristiques et avantages ressortiront de la description de l'invention qui va suivre, description donnée à titre d'exemple uniquement, en regard des dessins annexés parmi lesquels :
- La figure 1 est une représentation schématique d'un harnais électrique illustrant un mode de réalisation de l'art antérieur,
- La figure 2 est une vue latérale d'un aéronef,
- La figure 3 est une vue latérale d'un harnais électrique illustrant un mode de réalisation de l'invention,
- La figure 4 est une représentation schématique d'un harnais électrique illustrant un premier mode de réalisation de l'invention,
- La figure 5 est une coupe transversale du harnais électrique visible sur la figure 4, et
- La figure 6 est une coupe transversale d'un harnais électrique illustrant un autre mode de réalisation de l'invention.

Selon un mode de réalisation visible sur les figures 3 à 6, un harnais électrique 20 comprend au moins une liaison électrique 22 comportant au moins un élément conducteur ainsi qu'un système de protection électromagnétique 24 entourant la liaison électrique 22.

Ce système de protection électromagnétique 24 permet d'obtenir un blindage, autour de la liaison électrique 22, configuré pour la protéger des perturbations électromagnétiques générées par des éléments extérieurs et protéger des éléments extérieurs au harnais électrique 20 des perturbations électromagnétiques générées par la liaison électrique 22.

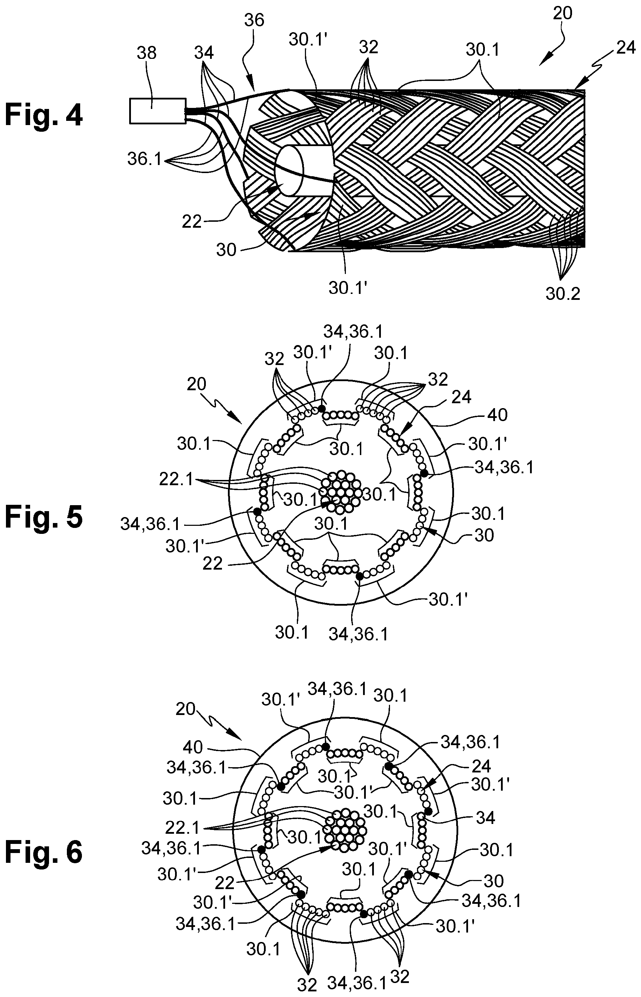

La liaison électrique 22 peut comprendre plusieurs éléments conducteurs 22.1, comme illustré sur les figures 5 et 6, comportant chacun une enveloppe isolante comme une gaine en matière plastique par exemple.

Selon une application visible sur la figure 2, un aéronef 26 comprend une installation électrique 28 comportant au moins une source d'alimentation électrique à haute tension 28.1, au moins un équipement utilisateur 28.2 ainsi qu'au moins un harnais électrique 20 reliant la source d'alimentation électrique à haute tension 28.1 et l'équipement utilisateur 28.2. Selon une configuration, la source d'alimentation électrique à haute tension fournit une tension continue de l'ordre de + ou - 270 Volts DC, ou encore de + ou - 540 Volts DC. Bien entendu, l'invention n'est pas limitée à cette application ou à ces tensions.

Le système de protection électromagnétique 24 comprend une enveloppe tubulaire 30 obtenue par tressage et positionnée autour de la liaison électrique. Cette enveloppe tubulaire 30 comprend plusieurs fuseaux 30.1 comportant chacun d'eux plusieurs brins 32, 34. Selon un mode de réalisation, l'enveloppe tubulaire 30 comprend seize fuseaux 30.1 de cinq brins 32, 34 chacun. Bien entendu, l'invention n'est pas limitée à ce nombre de fuseaux ou de brins pour chaque fuseau. De plus, le diamètre élémentaire de chaque brin peut varier dans un même fuseau ou entre deux fuseaux. La majorité des brins 32 des différents fuseaux 30.1 sont métalliques pour obtenir le système de protection électromagnétique 24. Selon un mode de réalisation, les brins 32 métalliques sont à base de cuivre nickelé ou étamé ou argenté.

Selon une configuration, les brins 32 métalliques ont un diamètre de l'ordre de 150 à 250 µm. Quelle que soit la configuration, pour obtenir le système de protection électromagnétique 24, les brins 32 métalliques doivent recouvrir au moins 85% de la surface de l'enveloppe tubulaire 30. De plus, l'enveloppe tubulaire 30 doit présenter à basse fréquence une résistance linéique de l'ordre de 5 mOhm/m et une inductance de l'ordre de 2 nH.

Pour obtenir ces caractéristiques, au moins 80% des brins 32 des fuseaux 30.1, 30.1' de l'enveloppe tubulaire 30 sont métalliques. De préférence, au moins 90% des brins 32 sont métalliques. Selon une répartition, une moitié ou plus des fuseaux 30.1 est réalisée exclusivement à partir de brins 32 métalliques, les autres fuseaux 30.1' comportant au moins 75% de brins 32 métalliques.

Selon un agencement, tous les fuseaux 30.1 ont le même nombre de brins 32, 34. Chaque fuseau 30.1, 30.1' se présente sous la forme d'une nappe de brins 32, 34 juxtaposés les uns à côté des autres. Ainsi, chaque fuseau 30.1, 30.1' comprend un premier brin d'extrémité 32, 34 ainsi qu'un deuxième brin d'extrémité 32, 34 le plus écarté possible du premier brin d'extrémité.

Selon un premier mode de réalisation visible sur les figures 4 et 5, 75% des fuseaux 30.1 sont réalisés exclusivement à partir de brins 32 métalliques, les autres fuseaux 30.1' comportant au moins 80% de brins 32 métalliques, soit quatre brins 32 métalliques sur cinq brins.

Selon un deuxième mode de réalisation visible sur la figure 6, 50% des fuseaux 30.1 sont réalisés exclusivement à partir de brins 32 métalliques, les autres fuseaux 30.1' comportant au moins 80% de brins 32 métalliques, soit quatre brins 32 métalliques sur cinq brins.

Selon un mode de réalisation visible sur la figure 3, le harnais électrique 20 comprend également un système de détection d'arcs électriques 36 comportant au moins une fibre optique 36.1 positionnée à proximité de la liaison électrique 22, au moins un composant de photo-détection 36.2 configuré pour recevoir un faisceau lumineux guidé par la fibre optique 36.1 et émettre un signal électrique en fonction du faisceau lumineux reçu ainsi qu'au moins une commande 36.3 configurée pour émettre au moins un signal de commande en fonction du signal électrique émis par le composant de photo-détection 36.2. Plus précisément, la au moins une fibre optique 36.1 est positionnée au moins en partie autour de la liaison électrique 22.

Selon une configuration, le système de détection d'arcs électriques 36 comprend également au moins un coupe-circuit positionné sur la liaison électrique 22, la scindant en des tronçons amont et aval, configuré pour occuper un état fermé dans lequel il laisse passer le courant entre les tronçons amont et aval de la liaison électrique 22 ainsi qu'un état ouvert dans lequel il interrompt la circulation du courant entre les tronçons amont et aval de la liaison électrique 22 à réception d'un signal de commande transmis par la commande 36.3. Le système de détection d'arcs électriques 36 n'est pas limité à cette fonction d'ouverture de circuit électrique. Ainsi, il peut assurer une fonction de verrouillage optique au moment de l'allumage (fonction de mise en sécurité de la liaison électrique en cas de déconnection par un opérateur de maintenance) ou toute autre fonction.

Chaque fibre optique 36.1 comprend au moins un tronçon formant un brin 34 d'un des fuseaux 30.1' de l'enveloppe tubulaire 30 du système de protection électromagnétique 24. Selon une configuration, une même fibre optique 36.1 comprend plusieurs tronçons formant chacun un brin 34 de différents fuseaux 30.1'. Selon une autre configuration visible sur la figure 4, chaque fibre optique 36.1 comprend un unique tronçon formant un brin 34 d'un fuseau 30.1'.

Selon ces deux configurations, tous les brins 34 non métalliques sont des tronçons de fibre optique 36.1. Ainsi, les brins 32, 34 des fuseaux 30.1, 30.1' de l'enveloppe tubulaire 30 sont exclusivement métalliques ou sous la forme de tronçons de fibre optique 36.1. Ainsi, selon l'invention, la même enveloppe tubulaire 30 comprend des brins 32 métalliques formant au moins une partie du système de protection électromagnétique 24 ainsi que des brins 34 sous la forme de tronçons de fibre optique 36.1 formant au moins une partie du système de détection d'arcs électriques 36. Cette solution contribue à réduire la masse d'un harnais électrique 20 intégrant les fonctions de protection électromagnétique et de détection d'arcs électriques. Selon un mode de réalisation, les brins 34 sous la forme de tronçons de fibre optique 36.1 sont régulièrement répartis autour de la liaison électrique 22.

Selon un premier mode de réalisation visible sur les figures 4 et 5, l'enveloppe tubulaire 30 comprend quatre brins 34, chacun sous la forme d'un tronçon de fibre optique 36.1, régulièrement répartis autour de la liaison électrique 22 dans quatre fuseaux 30.1'. Ainsi, un fuseau 30.1' sur quatre comprend un brin 34 sous la forme d'un tronçon de fibre optique 36.1. Selon ce premier mode de réalisation, chaque tronçon de fibre optique 36.1 assure la détection d'arcs électriques sur un secteur angulaire de l'ordre de 90°.

Selon un deuxième mode de réalisation visible sur la figure 6, l'enveloppe tubulaire 30 comprend huit brins 34, sous la forme chacun d'un tronçon de fibre optique 36.1, régulièrement répartis autour de la liaison électrique 22 dans huit fuseaux 30.1. Selon un premier agencement, un fuseau 30.1' sur deux comprend un brin 34 sous la forme d'un tronçon de fibre optique 36.1. Selon un deuxième agencement visible sur la figure 6, l'enveloppe tubulaire 30 comprend plusieurs couples de fuseaux adjacents 30.1' séparés par deux fuseaux 30.1 comportant exclusivement des brins 32 métalliques. Pour chaque couple de fuseaux adjacents 30.1', les premier et deuxième brins d'extrémité, les plus espacés, sont chacun sous la forme d'un tronçon de fibre optique 36.1, les autres brins 32 de chaque couple de fuseaux adjacents 30.1' étant métalliques. Selon ces deux agencements, les brins 34 sous forme de tronçons de fibre optique 36.1 sont régulièrement répartis autour de la liaison électrique 22, chaque tronçon de fibre optique 36.1 assurant la détection d'arcs électriques sur un secteur angulaire de l'ordre de 45°.

Selon les premier et deuxième modes de réalisation, la moitié ou moins des fuseaux 30.1, 30.1' comprennent chacun au plus un brin 34 sous la forme d'un tronçon de fibre optique.

Les brins 34 sous la forme de tronçons de fibre optique 36.1 ont un diamètre sensiblement identique à celui des brins 32 métalliques, de l'ordre de 150 à 250 µm.

Selon une configuration, chaque fibre optique est une fibre optique standard multimode, par exemple de diamètre 50/125 ou 62.5/125. Selon une autre configuration, chaque fibre optique est une fibre optique monomode, par exemple de diamètre 9/125. Bien entendu, l'invention n'est pas limitée à ces diamètres de fibre optique, mais une fibre optique multimode ou monomode de diamètre différent pourrait être utilisée.

Selon un mode de réalisation, les fibres optiques 36.1 sont des fibres optiques plastiques dites POF (pour Polymer Optical Fiber en anglais) et/ou des fibres à cristal photonique dites PCF (pour Polymer Cladded Fiber). Quel que soit le mode de réalisation, les fibres optiques 36.1 sont configurées pour fonctionner à des températures de l'ordre de 150 à 180 °C et présentent des caractéristiques mécaniques permettant le tressage ou le surtressage.

Selon un mode de réalisation visible sur les figures 3 et 4, les tronçons de fibre optique 36.1 sont reliés en parallèle.

Lorsque les tronçons de fibre optique 36.1 sont reliés en parallèle, les tronçons de fibre optique 36.1 sont reliés par au moins une férule 38 à chaque extrémité de l'enveloppe tubulaire 30. A titre d'exemple, chaque férule 38 est utilisée comme un contact mâle destiné à être inséré dans un connecteur mâle et présente une taille 8.

Chaque brin 34 sous la forme d'un tronçon de fibre optique 36.1 s'étend sur toute la longueur de l'enveloppe tubulaire 30, comme les brins 32 métalliques, et présente au moins une surlongueur à au moins une extrémité de l'enveloppe tubulaire 30. Ainsi, chaque férule 38 est espacée de l'extrémité de l'enveloppe tubulaire 30. Cette configuration permet de simplifier le raccordement des tronçons de fibre optique entre eux. Selon un mode de réalisation, chaque brin 34 sous la forme d'un tronçon de fibre optique 36.1 présente une surlongueur à chaque extrémité de l'enveloppe tubulaire 30.

Le composant de photo-détection 36.2 et la commande 36.3 du système de détection d'arcs électriques 36 ne sont pas plus décrits car ils peuvent être identiques à ceux de l'art antérieur. Selon un mode opératoire, l'enveloppe tubulaire 30 est obtenue par un surtressage simultané sur la liaison électrique 22 de brins 32 métalliques formant au moins une partie du système de protection électromagnétique 24 ainsi que de brins 34 sous la forme de tronçons de fibre optique 36.1 formant au moins une partie du système de détection d'arcs électriques 36 de manière à obtenir une unique enveloppe tubulaire 30 entourant la liaison électrique 22.

A titre d'exemple, le procédé de surtressage comprend :
- une étape de mise en bobine de brins 32 métalliques et de brins 34 sous la forme de tronçons de fibre optique 36.1,
- une étape de mise en place des bobines sur une machine de surtressage,
- une étape de réglage des ressorts de tension de la machine de surtressage,
- une étape de réglage de l'angle de tressage,
- une étape de tressage de l'enveloppe tubulaire 30 autour de la liaison électrique 22.

Cette solution permet de garantir que l'enveloppe tubulaire 30 soit en contact avec la liaison électrique 22 et présente un diamètre et donc une masse les plus faibles possible. De plus, cette solution permet d'obtenir, à l'issue du procédé de surtressage, une unique enveloppe tubulaire 30 intégrant le système de protection électromagnétique 24 et le système de détection d'arcs électriques 36.

Selon un mode de réalisation, le harnais électrique 20 peut comprendre une gaine de protection intercalée entre l'enveloppe tubulaire 30 et la liaison électrique 22, par exemple en polytétrafluoroéthylène (PTFE), pour protéger la liaison électrique 22 lors du surtressage et/ou une protection mécanique 40 rapportée sur l'enveloppe tubulaire 30, comme une gaine obtenue par surtressage de fibres synthétiques, en aramide par exemple.

## Revendications

1. Harnais électrique (20) comportant :
- au moins une liaison électrique (22),
- un système de protection électromagnétique (24) comportant une enveloppe tubulaire (30) obtenue par tressage de fuseaux (30.1, 30.1') de brins (32, 34) et positionnée autour de la liaison électrique (22), au moins 80% des brins (32) des fuseaux (30.1, 30.1') étant métalliques,
- un système de détection d'arcs électriques (36) comportant au moins une fibre optique (36.1) positionnée à proximité de la liaison électrique (22) et au moins un composant de photo-détection (36.2) configuré pour recevoir un faisceau lumineux guidé par la fibre optique (36.1),
dans lequel l'enveloppe tubulaire (30) comprend des brins (34) sous la forme de tronçons de fibre optique (36.1) formant au moins une partie du système de détection d'arcs électriques (36), et **caractérisé en ce que** les brins (34) sous la forme de tronçons de fibre optique (36.1) ont un diamètre sensiblement identique à celui des brins (32) métalliques.

2. Harnais électrique (20) selon la revendication 1, **caractérisé en ce que** pour au moins une moitié des fuseaux (30.1) de l'enveloppe tubulaire (50), tous les brins (32) sont métalliques alors que pour les autres fuseaux (30.1') de l'enveloppe tubulaire (30), au moins 75% des brins (32) étant métalliques.

3. Harnais électrique (20) selon la revendication précédente, **caractérisé en ce que** l'enveloppe tubulaire (30) comprend seize fuseaux (30.1, 30.1') ainsi que quatre brins (34), chacun sous la forme d'un tronçon de fibre optique (36.1), régulièrement répartis autour de la liaison électrique (22) dans quatre fuseaux (30.1').

4. Harnais électrique (20) selon la revendication 2, **caractérisé en ce que** l'enveloppe tubulaire (30) comprend seize fuseaux (30.1, 30.1') ainsi que huit brins (34), chacun sous la forme d'un tronçon de fibre optique (36.1), régulièrement répartis autour de la liaison électrique (22) dans huit fuseaux (30.1').

5. Harnais électrique (20) selon l'une des revendications précédentes, **caractérisé en ce que** chaque fibre optique (36.1) est une fibre optique monomode ou multimode.

6. Harnais électrique (20) selon l'une des revendications précédentes, **caractérisé en ce que** les tronçons de fibre optique (36.1) sont reliés en parallèle.

7. Harnais électrique (20) selon l'une des revendications précédentes, **caractérisé en ce que** chaque brin (34) sous la forme d'un tronçon de fibre optique (36.1) s'étend sur toute la longueur de l'enveloppe tubulaire (30) et présente au moins une surlongueur à au moins une extrémité de l'enveloppe tubulaire (30).

8. Procédé de fabrication d'un harnais électrique (20) selon l'une des revendications précédentes, **caractérisé en ce que** l'enveloppe tubulaire (30) est obtenue par un surtressage simultané, sur la liaison électrique (22), de brins (32) métalliques formant au moins une partie du système de protection électromagnétique (24) ainsi que de brins (34) sous la forme de tronçons de fibre optique (36.1) formant au moins une partie du système de détection d'arcs électriques (36).

9. Aéronef comprenant au moins un harnais électrique (20) selon l'une des revendications 1 à 7.

## Patentansprüche

1. Elektrischer Kabelbaum (20) mit:
- wenigstens einer elektrischen Verbindung (22),
- einem elektromagnetischen Schutzsystem (24) mit einer schlauchförmigen Hülle (30), die durch Flechten von Bändern (30.1, 30.1') aus Strängen (32, 34) erhalten wird und die um die elektrische Verbindung (22) herum angeordnet ist, wobei wenigstens 80% der Stränge (32) der Bänder (30.1, 30.1') metallisch sind,
- einem Lichtbogenerkennungssystem (36) mit wenigstens einem Lichtwellenleiter (36.1), der in der Nähe der elektrischen Verbindung (22) angeordnet ist, und mit wenigstens einer Fotodetektorkomponente (36.2), die so eingerichtet ist, dass sie einen von dem Lichtwellenleiter (36.1) geführten Lichtstrahl empfängt,
wobei die schlauchförmige Hülle (30) Stränge (34) in Form von Lichtwellenleiterabschnitten (36.1) aufweist, die wenigstens einen Teil des Lichtbogenerkennungssystems (36) bilden, und **dadurch gekennzeichnet, dass** die Stränge (34) in Form von Lichtwellenleiterabschnitten (36.1) einen Durchmesser haben, der im Wesentlichen identisch mit dem der metallischen Strängen (32) ist.

2. Elektrischer Kabelbaum (20) nach Anspruch 1, **dadurch gekennzeichnet, dass** bei wenigstens einer Hälfte der Bänder (30.1) der schlauchförmigen Hülle (50) alle Stränge (32) aus Metall sind, während bei den anderen Bändern (30.1') der schlauchförmigen Hülle (30) wenigstens 75% der Stränge (32) aus Metall sind.

3. Elektrischer Kabelbaum (20) nach dem vorhergehenden Anspruch, **dadurch gekennzeichnet, dass** die schlauchförmige Hülle (30) sechzehn Bänder (30.1, 30.1') sowie vier Stränge (34) aufweist, jeweils in Form eines Lichtwellenleiterabschnitts (36.1), die gleichmäßig um die elektrische Verbindung (22) herum auf vier Bändern (30.1') verteilt sind.

4. Elektrischer Kabelbaum (20) nach Anspruch 2, **dadurch gekennzeichnet, dass** die schlauchförmige Hülle (30) sechzehn Bänder (30.1, 30.1') sowie acht Stränge (34) aufweist, jeweils in Form eines Lichtwellenleiterabschnitts (36.1), die gleichmäßig um die elektrische Verbindung (22) herum auf acht Bänder (30.1') verteilt sind.

5. Elektrischer Kabelbaum (20) nach einem der vorhergehenden Ansprüche, **dadurch gekennzeichnet, dass** jeder Lichtwellenleiter (36.1) eine Singlemode- oder Multimode-Lichtleitfaser ist.

6. Elektrischer Kabelbaum (20) nach einem der vorhergehenden Ansprüche, **dadurch gekennzeichnet, dass** die Lichtwellenleiterabschnitte (36.1) parallel verbunden sind.

7. Elektrischer Kabelbaum (20) nach einem der vorhergehenden Ansprüche, **dadurch gekennzeichnet, dass** sich jeder Strang (34) in Form eines Lichtwellenleiterabschnitts (36.1) über die gesamte Länge der schlauchförmigen Hülle (30) erstreckt und an wenigstens einem Ende der schlauchförmigen Hülle (30) wenigstens eine Überlänge aufweist.

8. Verfahren zur Herstellung eines elektrischen Kabelbaums (20) nach einem der vorhergehenden Ansprüche, **dadurch gekennzeichnet, dass** die schlauchförmige Hülle (30) durch gleichzeitiges Überflechten der elektrischen Verbindung (22) mit metallischen Strängen (32), die wenigstens einen Teil des elektromagnetischen Schutzsystems (24) bilden, sowie mit Strängen (34) in Form von Lichtwellenleiterabschnitten (36.1) erhalten wird, die wenigstens einen Teil des Systems zur Erkennung von Lichtbögen (36) bilden.

9. Luftfahrzeug mit wenigstens einem elektrischen Kabelbaum (20) nach einem der Ansprüche 1 bis 7.

## Claims

1. Electrical harness (20) comprising:
- at least one electrical connection (22),
- an electromagnetic protection system (24) comprising a tubular jacket (30) obtained by braiding bundles (30.1, 30.1') of strands (32, 34) and positioned around the electrical connection (22), at least 80% of the strands (32) of the bundles (30.1, 30.1') being made of metal,
- a system (36) for detecting electric arcs which comprises at least one optical fiber (36.1) positioned close to the electrical connection (22) and at least one photodetection component (36.2) configured to receive a light beam guided by the optical fiber (36.1),
wherein the tubular jacket (30) comprising strands (34) in the form of segments of optical fiber (36.1) forming at least part of the system (36) for detecting electric arcs, and **characterized in that** the strands (34) in the form of segments of optical fiber (36.1) have a diameter that is substantially identical to that of the metal strands (32).

2. Electrical harness (20) as claimed in claim 1, wherein all the strands (32) are made of metal for at least half of the bundles (30.1) of the tubular jacket (30) while at least 75% of the strands (32) are made of metal for the other bundles (30.1') of the tubular jacket (30).

3. Electrical harness (20) as claimed in the preceding claim, wherein the tubular jacket (30) comprises sixteen bundles (30.1, 30.1') and four strands (34), each in the form of a segment of optical fiber (36.1), regularly distributed around the electrical connection (22) in four bundles (30.1').

4. Electrical harness (20) as claimed in claim 2, wherein the tubular jacket (30) comprises sixteen bundles (30.1, 30.1') and eight strands (34), each in the form of a segment of optical fiber (36.1), regularly distributed around the electrical connection (22) in eight bundles (30.1').

5. Electrical harness (20) as claimed in one of the preceding claims, wherein each optical fiber (36.1) is a single-mode or multi-mode optical fiber.

6. Electrical harness (20) as claimed in one of the preceding claims, wherein the segments of optical fiber (36.1) are connected in parallel.

7. Electrical harness (20) as claimed in one of the preceding claims, wherein each strand (34) in the form of a segment of optical fiber (36.1) extends over the entire length of the tubular jacket (30) and has at least one excess length at at least one end of the tubular jacket (30).

8. Process for manufacturing an electrical harness (20) as claimed in one of the preceding claims, wherein the tubular jacket (30) is obtained by simultaneously overbraiding, on the electrical connection (22), metal strands (32) forming at least part of the electromagnetic protection system (24) and strands (34) in the form of segments of optical fiber (36.1) forming at least part of the system (36) for detecting electric arcs.

9. Aircraft comprising at least one electrical harness (20) as claimed in one of claims 1 to 7.
